# EUROPEAN PATENT APPLICATION

(11) **EP 4 240 118 A1**
(43) Date of publication of application: **06.09.2023**
(21) Application number: 22160311.1
(22) Date of filing: 04.03.2022
(51) Int. Cl.: H05K 1/02, H05K 1/11

(54) **MULTILAYER PRINTED CIRCUIT BOARD**

(71) Applicant: ZF CV Systems Europe BV, 1170 Brüssel (BE)
(72) Inventor: CALKA, Marcin, 54-404 Wroclaw (PL)
(74) Representative: Rabe, Dirk-Heinrich

(57) **Abstract**

The invention is related to a multilayer printed circuit board (1). The invention is further related to an electronic control unit for a motor vehicle comprising such a multilayer printed circuit board (1), and to a motor vehicle comprising such an electronic control unit. The multilayer printed circuit board (1) comprises a bottom layer (Ln), a top layer (L1), and two or more inner layers (L2 - Ln-1). A heat receiving area (2) of the top layer (L1) is thermally connected to an upper adjacent inner layer (L2) by one or more blind vias (3) and a heat dissipating area (4) of the bottom layer (Ln) is thermally connected to a lower adjacent inner layer (Ln-1) by one or more blind vias (3). The two or more inner layers (L2 - Ln-1) are thermally connected by a plurality of buried vias (5). The plurality of buried vias (5) are arranged to form an interleaved heat exchange structure (13) for a heat exchange between the top layer (L1) and the bottom layer (Ln).

## Description

The invention is related to a multilayer printed circuit board comprising a bottom layer, a top layer, and two or more inner layers. The invention is further related to an electronic control unit for a motor vehicle comprising such a multilayer printed circuit board, and to a motor vehicle comprising such an electronic control unit.

During operation of a component that is soldered to a printed circuit board, a lot of heat is often generated within the component. In order to avoid damage of the component, there is a need to provide an effective way of cooling the component. A currently used cooling solution is to provide vias and copper areas under the component, using all layers of the printed circuit board to spread the heat coming from the component. In other words, cooling wells are formed, which extend through the whole layer stack of the printed circuit board.

However, is has been found that heat dissipation using this solution is often not sufficient, in particular due to increased complexity of the designs and components, larger currents, or the requirements specified for the system. Heat is cumulated in a thermally separated area, which may cause overheating of the components and may eventually lead to damage of the components.

It is an object of the present invention to provide a multilayer printed circuit board with an improved heat dissipation capability.

The invention is as set out in the independent claims 1,13, and 14. Preferred embodiments are defined by the dependent claims.

According to the invention, a multilayer printed circuit board comprises a bottom layer, a top layer, and two or more inner layers. A heat receiving area of the top layer is thermally connected to an upper adjacent inner layer by one or more blind vias. A heat dissipating area of the bottom layer is thermally connected to a lower adjacent inner layer by one or more blind vias. The two or more inner layers are thermally connected by a plurality of buried vias. The plurality of buried vias are arranged to form an interleaved heat exchange structure for a heat exchange between the top layer and the bottom layer. The blind vias may be realized as micro vias.

The solution according to the invention has the advantage that heat dissipation is not limited to a volume of the multilayer printed circuit board that is located below the component to be cooled. Instead, a special structure of layers and vias is formed, which forms a heat exchanger between two different potentials. Heat generated in the component is transferred by a first potential, which is connected to the exposed pad below the component, to a second potential, usually PCB ground, which has a huge heat dissipation ability within the printed circuit board and, depending on the design, also outside the printed circuit board. The structure of layers and vias is formed in such way that there is only a small thermal resistance between the two potentials.

In a preferred embodiment, the top layer, the bottom layer, and the inner layers are provided with a heat conducting material. For example, the heat conducting material may be copper. Providing the layers with a heat conducting material allows improving the heat exchange between the two potentials. As copper has a good thermal conductivity, it is well-suited for this purpose. In addition, the coppers on the top layer may further serve as a pad for soldering a component to the top layer.

In a preferred embodiment, the heat receiving area of the top layer and the heat dissipating area of the bottom layer are electrically isolated from each other. In this way, the first potential is electrically isolated from the second potential, which allows to transfer heat from several components that need to be electrically isolated to the same heat dissipating area of the bottom layer.

In a preferred embodiment, the buried vias are arranged in columns. In this way, a very efficient heat transfer through the layer stack is achieved.

In a preferred embodiment, the columns are arranged in sheets. A first set of sheets is connected to the first potential, i.e. the top layer, whereas a second set of sheets is connected to the second potential, i.e. the bottom layer. The two sets of sheets are interleaved and form a comb-like heat exchange structure.

In a preferred embodiment, the columns are arranged in rings or rectangles. A first set of rings or rectangles is connected to the first potential, i.e. the top layer, whereas a second set of rings or rectangles is connected to the second potential, i.e. the bottom layer. The two sets of rings or rectangles are interleaved and form a nested heat exchange structure.

In a preferred embodiment, the columns are arranged in a chess pattern. A first set of columns is connected to the first potential, i.e. the top layer, whereas a second set of columns is connected to the second potential, i.e. the bottom layer. The two sets of columns are interleaved and form a brush-like heat exchange structure.

In a preferred embodiment, the multilayer printed circuit board comprises four inner layers. This is a good compromise between the achievable packing density and the cost of the multilayer printed circuit board. Of course, use of the solution according to the invention is not limited to this number of inner layers.

In a preferred embodiment, the multilayer printed circuit board further comprises a heat generating component arranged on the heat receiving area of the top layer. The heat generating component may be an electronic component that is part of an electronic system.

In a preferred embodiment, the heat receiving area of the top layer is larger than a footprint of the heat generating component. In this way, the number of blind vias thermally connecting the heat receiving area of the top layer to the upper adjacent inner layer can be increased, which leads to a more efficient heat transfer into the inner layers.

In a preferred embodiment, the heat dissipating area of the bottom layer is larger than the heat receiving area of the top layer. In this way, it can easily be ensured that the second potential has a large heat dissipation ability.

Advantageously, an electronic control unit for a motor vehicle comprises a multilayer printed circuit board according to the invention. As such an electronic control unit shows an improved heat dissipation capability, it can be used in a wider temperature range. Therefore, it is advantageous if a motor vehicle comprises such an electronic control unit.

Preferred embodiments of the disclosure are explained in more detail below by way of example with reference to schematic drawings, which show:
- Fig. 1: an exemplary detailed layer structure of a multilayer printed circuit board;
- Fig. 2: a cross section of a multilayer printed circuit board implementing a known cooling solution;
- Fig. 3: schematic top views of the layers of the multilayer printed circuit board of Fig. 2;
- Fig. 4: a cross section of a multilayer printed circuit board according to a first embodiment of the invention;
- Fig. 5: schematic top views of the layers of the multilayer printed circuit board of Fig. 4;
- Fig. 6: a cross section of a multilayer printed circuit board according to a second embodiment of the invention;
- Fig. 7: schematic top views of the layers of the multilayer printed circuit board of Fig. 6;
- Fig. 8: a cross section of a multilayer printed circuit board according to a third embodiment of the invention;
- Fig. 9: schematic top views of the layers of the multilayer printed circuit board of Fig. 8;
- Fig. 10: a cross section of a multilayer printed circuit board according to a fourth embodiment of the invention;
- Fig. 11: schematic top views of the layers of the multilayer printed circuit board of Fig. 10; and
- Fig. 12: a schematic view of a motor vehicle comprising an electronic control unit.

The present description illustrates the principles of the present disclosure. It will thus be appreciated that those skilled in the art will be able to devise various arrangements that, although not explicitly described or shown herein, embody the principles of the disclosure and are included within its scope.

All examples and conditional language recited herein are intended for instructional purposes to aid the reader in understanding the principles of the disclosure and the concepts contributed by the inventors to furthering the art, and are to be construed as being without limitation to such specifically recited examples and conditions. Moreover, all statements herein reciting principles, aspects, and embodiments of the disclosure, as well as specific examples thereof, are intended to encompass both structural and functional equivalents thereof.

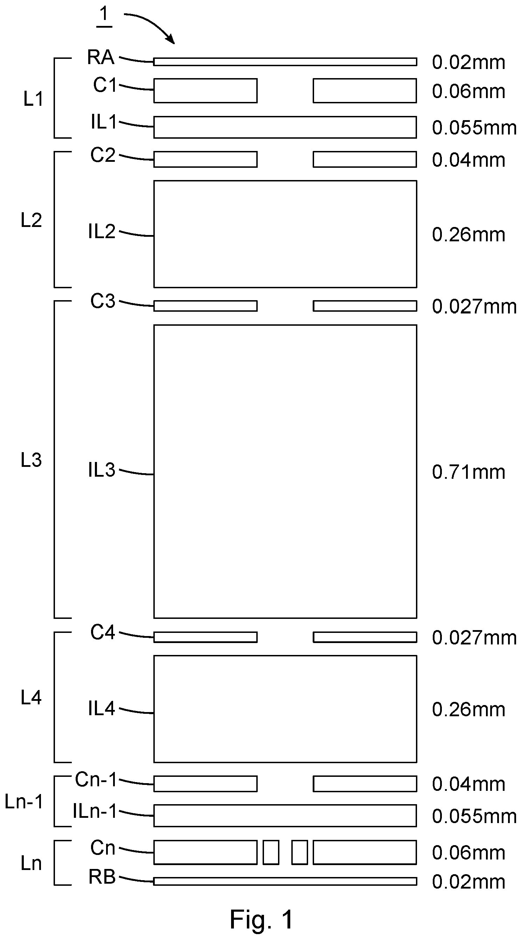

In Fig. 1 an exemplary detailed layer structure of a multilayer printed circuit board 1 is shown in an exploded view. In this example, the multilayer printed circuit board 1 has n layers L1 - Ln, each consisting of two or more sub-layers. The top layer L1 consists of an insulation layer IL1 with a thickness of 0.055mm, on which a conductor layer C1 with a thickness of 0.06mm and an top resist layer RA with a thickness of 0.02mm are arranged. The first, upper adjacent inner layer L2 consists of an insulation layer IL2 with a thickness of 0.26mm, on which a conductor layer C2 with a thickness of 0.04mm is arranged. The second inner layer L3 consists of an insulation layer IL3 with a thickness of 0.71mm, on which a conductor layer C3 with a thickness of 0.027mm is arranged. The third inner layer L4 consists of an insulation layer IL4 with a thickness of 0.26mm, on which a conductor layer C4 with a thickness of 0.027mm is arranged. The lower adjacent inner layer Ln-1 consists of an insulation layer ILn-1 with a thickness of 0.055mm, on which a conductor layer Cn-1 with a thickness of 0.04mm is arranged. The bottom layer Ln consists of a bottom resist layer RB with a thickness of 0.02mm, on which a conductor layer Cn with a thickness of 0.06mm is arranged. Of course, the thicknesses and numbers of the various layers are only examples. Other thicknesses and numbers of layers adapted to the requirements of the multilayer printed circuit board 1 may be used. Typically, the conducting material of the conductor layers C1-Cn is copper.

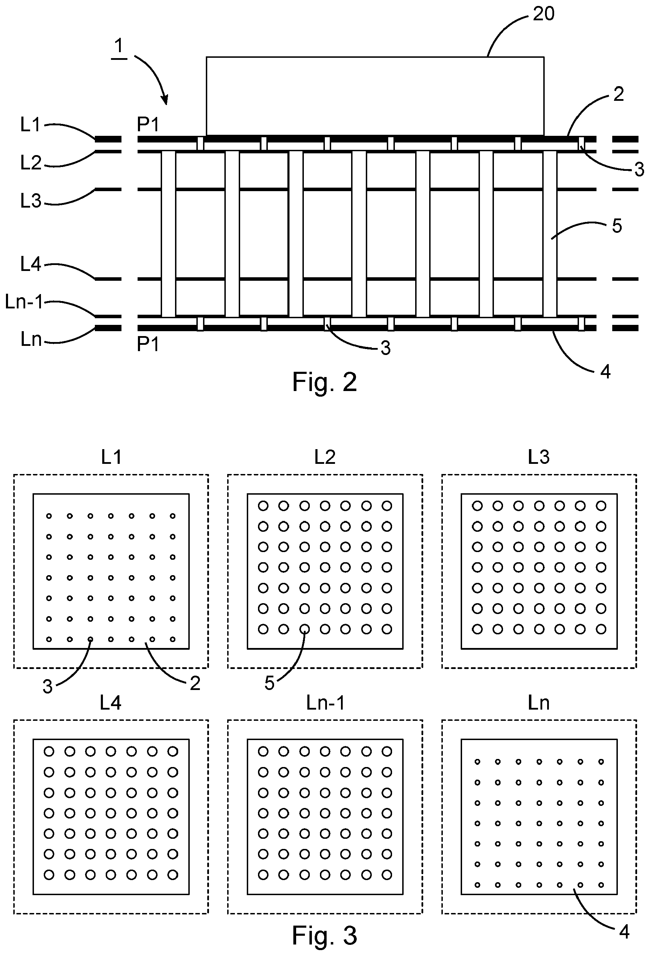

Fig. 2 shows a schematic cross section of a multilayer printed circuit board 1 implementing a known cooling solution. For simplicity, for each layer L1 - Ln only the conductors of the respective conductor layer are shown. Arranged on the multilayer printed circuit board 1 is a heat generating component 20, e.g., a microchip. The heat generating component 20 is soldered to the top layer L1, i.e., to a copper area of the top layer L1, which is located below the heat generating component 20. This copper area constitutes a heat receiving area 2 for heat generated by the heat generating component 20. Similar copper areas are arranged on the inner layers L2 - Ln-1 and the bottom layer Ln. The heat receiving area 2 is thermally connected to an upper adjacent inner layer L2 by a plurality of blind vias 3. Similarly, the copper area of the bottom layer Ln, which constitutes a heat dissipating area 4, is thermally connected to a lower adjacent inner layer Ln-1 by a plurality of blind vias 3. The inner layers L2 - Ln-1 are thermally connected by a plurality of buried vias 5. The buried vias 5 form columns trough the inner layers L2 - Ln-1. According to the depicted cooling solution, vias 3, 5 and copper areas are provided under the heat generating component 20, using all layers L1 - Ln of the multilayer printed circuit board 1 to spread the heat coming from the heat generating component 20. In other words, cooling wells are formed, which extend through the whole layer stack of the multilayer printed circuit board 1.However, the potential of the connected vias 3, 5 and the copper areas is the same as the potential P1 of the heat receiving area 2 that is exposed to the heat generated by the heat generating component 20. Therefore, heat is cumulated in a thermally separated area, which may cause overheating of the heat generating component 20 and may eventually lead to damage of the heat generating component 20.

Fig. 3 shows schematic top views of the layers L1 - Ln of the multilayer printed circuit board of Fig. 2. As can be seen, in this example 49 blind vias 3 are provided in the top layer L1, which thermally connect the heat receiving area 2, i.e., the copper area of the top layer L1, to the copper area of the upper adjacent inner layer L2. Similarly, 49 blind vias 3 are provided in the bottom layer Ln, which thermally connect the heat dissipating area 4, i.e., the copper area of the bottom layer Ln, to the copper area of the lower adjacent inner layer Ln-1. The inner layers L2 - Ln-1 are thermally connected by 49 buried vias 5. Of course, other numbers of blind vias 3 and buried vias 5 may be used.

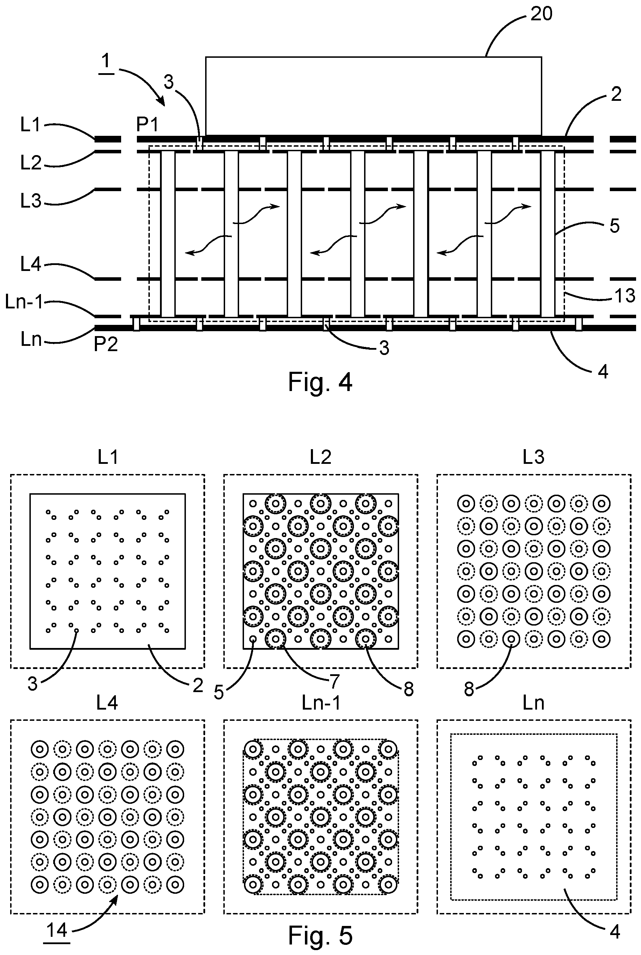

Fig. 4 shows a schematic cross section of a multilayer printed circuit board 1 according to a first embodiment of the invention. Again, for simplicity only the conductors of the respective conductor layer are shown for each layer L1 - Ln. Arranged on the multilayer printed circuit board 1 is a heat generating component 20. The heat generating component 20 is soldered to the top layer L1, i.e., to a copper area of the top layer L1, which is located below the heat generating component 20. This copper area constitutes a heat receiving area 2 for heat generated by the heat generating component 20. Further copper areas are arranged on the inner layers L2 - Ln-1 and the bottom layer Ln. The heat receiving area 2 is thermally connected to an upper adjacent inner layer L2 by a plurality of blind vias 3. Similarly, the copper area of the bottom layer Ln, which constitutes a heat dissipating area 4, is thermally connected to a lower adjacent inner layer Ln-1 by a plurality of blind vias 3. The inner layers L2 - Ln-1 are thermally connected by a plurality of buried vias 5. The buried vias 5 form columns trough the inner layers L2 - Ln-1. In this case, however, the buried vias 5 are arranged to form an interleaved heat exchange structure 13 for a heat exchange between the top layer L1 and the bottom layer Ln. The heat exchange is indicated by the arrows emanating from the buried vias 5. As can be seen, there is no continuous metallic connection between the top layer L1 and the bottom layer Ln. In particular, those buried vias 5 that are in connection with the heat receiving area 2, by means of the blind vias 3 connecting the top layer L1 and the upper inner layer L2, are not in connection with the heat dissipating area 4. Accordingly, those buried vias 5 that are in connection with the heat dissipating area 4, by means of the blind vias 3 connecting the bottom layer Ln and the lower inner layer Ln-1, are not in connection with the heat receiving area 2. In this way, heat dissipation is not limited to a volume of the multilayer printed circuit board 1 that is located below the heat generating component 20. Instead, heat generated in the component 20 is transferred by a first potential P1, which is connected to the heat receiving area 2 below the heat generating component 20, to a second potential P2, which can be the main conductive potential of the PCB, which has a huge heat dissipation ability within the printed circuit board 1 and, depending on the design, also outside the printed circuit board 1. The structure of layers L1 - Ln and vias 3, 5 is formed in such way that there is only a small thermal resistance between the two potentials P1, P2.

Fig. 5 shows schematic top views of the layers L1 - Ln of the multilayer printed circuit board of Fig. 4. As can be seen, 72 blind vias 3 are provided in the top layer L1, which thermally connect the heat receiving area 2, i.e., the copper area of the top layer L1, to the copper area of the upper adjacent inner layer L2. Similarly, 72 blind vias 3 are provided in the bottom layer Ln, which thermally connect the heat dissipating area 4, i.e., the copper area of the bottom layer Ln, to the copper area of the lower adjacent inner layer Ln-1. The inner layers L2 - Ln-1 are thermally connected by 49 buried vias 5. Of course, other numbers of blind vias 3 and buried vias 5 may be used. The copper area of the upper adjacent inner layer L2 consists of one large copper area, which is thermally connected to the top layer L1 and hence to the first potential P1, and a plurality of small circular copper areas 8, which are arranged in corresponding cut-outs 7 of the large copper area. These small circular copper areas 8 are connected to the second potential P2, which is indicated through their short-dashed outline. In this example, the cut-outs 7 are circular cut-outs. Of course, also other shapes may be used. In the inner layers L3, L4, the copper area consists of a plurality of small circular copper areas 8. A subset of these small circular copper areas 8 is connected to the second potential P2, which is indicated through the short-dashed outline, whereas another subset is connected to the first potential P1, which is indicated through the solid outline. The lower adjacent inner layer Ln-1 consists of one large copper area, which is thermally connected to the bottom layer Ln and hence to the second potential P2, which is indicated through the short-dashed outline, and a plurality of small circular copper areas 8, which are arranged in corresponding cut-outs 7 of the large copper area. These small circular copper areas 8 are connected to the first potential P1, which is indicated through their solid outline. As is apparent, the columns formed by the buried vias 5 are arranged in a chess pattern 14. A first set of columns is connected to the first potential P1, i.e. the top layer L1, whereas a second set of columns is connected to the second potential P2, i.e. the bottom layer Ln. The two sets of columns are interleaved and form a brush-like heat exchange structure.

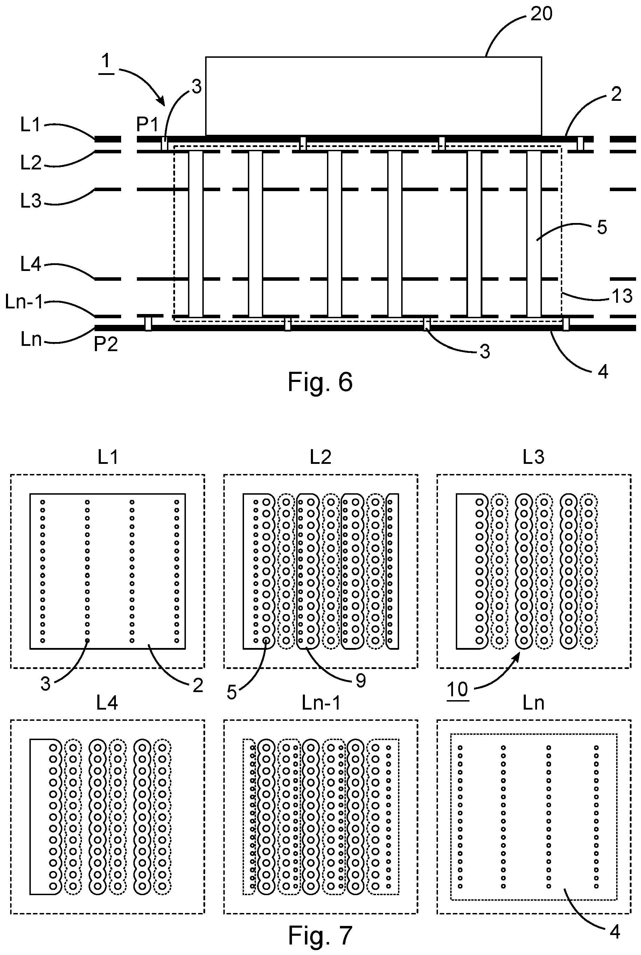

Fig. 6 shows a schematic cross section of a multilayer printed circuit board 1 according to a second embodiment of the invention. For simplicity only the conductors of the respective conductor layer are shown for each layer L1 - Ln. As before, a copper area of the top layer L1 is provided as a heat receiving area 2 for heat generated by a heat generating component. Further copper areas are arranged on the inner layers L2 - Ln-1 and the bottom layer Ln. The heat receiving area 2 is thermally connected to an upper adjacent inner layer L2 by a plurality of blind vias 3. Similarly, the copper area of the bottom layer Ln, which constitutes a heat dissipating area 4, is thermally connected to a lower adjacent inner layer Ln-1 by a plurality of blind vias 3. The inner layers L2 - Ln-1 are thermally connected by a plurality of buried vias 5. The buried vias 5 form columns trough the inner layers L2 - Ln-1. As before, the buried vias 5 are arranged to form an interleaved heat exchange structure 13 for a heat exchange between the top layer L1 and the bottom layer Ln.

Fig. 7 shows schematic top views of the layers of the multilayer printed circuit board 1 of Fig. 6. Again, 72 blind vias 3 are provided in the top layer L1, which thermally connect the heat receiving area 2, i.e., the copper area of the top layer L1, to the copper area of the upper adjacent inner layer L2. Similarly, 72 blind vias 3 are provided in the bottom layer Ln, which thermally connect the heat dissipating area 4, i.e., the copper area of the bottom layer Ln, to the copper area of the lower adjacent inner layer Ln-1. The inner layers L2 - Ln-1 are thermally connected by 72 buried vias 5. Of course, other numbers of blind vias 3 and buried vias 5 may be used. The copper areas of the inner layers L2 - Ln-1 consist of stripes 9. A first subset of these stripes 9 is connected to the first potential P1, which is indicated through the solid outline, whereas a second subset is connected to the second potential P2, which is indicated through the short-dashed outline. As is apparent, the columns formed by the buried vias 5 are arranged in sheets 10. A first set of sheets 10 is connected to the first potential P1, i.e. the top layer L1, whereas a second set of sheets 10 is connected to the second potential P2, i.e. the bottom layer Ln. The two sets of sheets 10 are interleaved and form a comb-like heat exchange structure.

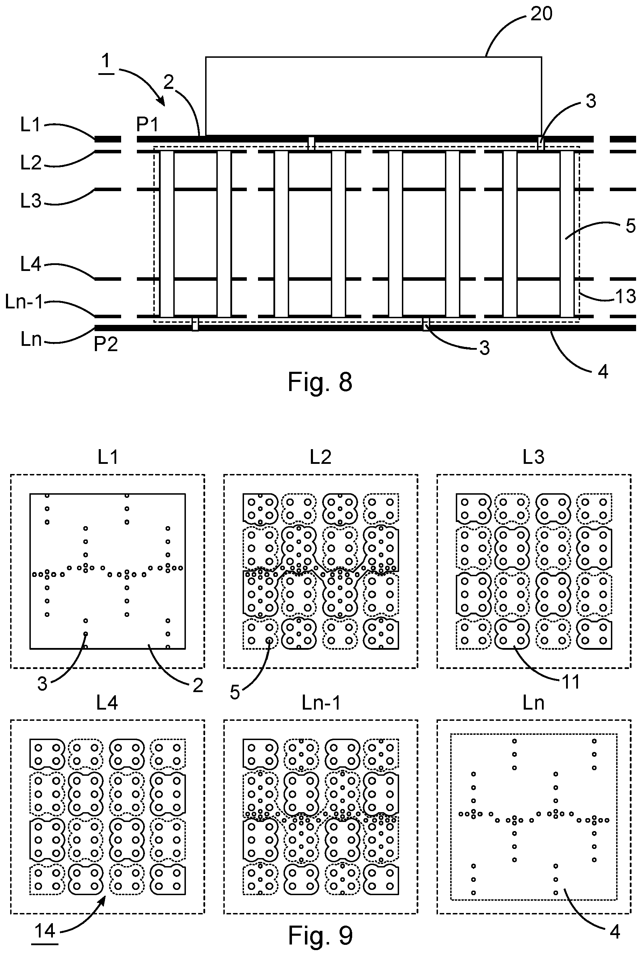

Fig. 8 shows a schematic cross section of a multilayer printed circuit board 1 according to a third embodiment of the invention. As before, only the conductors of the respective conductor layer are shown for each layer L1 - Ln. A copper area of the top layer L1 is provided as a heat receiving area 2 for heat generated by a heat generating component. Further copper areas are arranged on the inner layers L2 - Ln-1 and the bottom layer Ln. The heat receiving area 2 is thermally connected to an upper adjacent inner layer L2 by a plurality of blind vias 3. Similarly, the copper area of the bottom layer Ln, which constitutes a heat dissipating area 4, is thermally connected to a lower adjacent inner layer Ln-1 by a plurality of blind vias 3. The inner layers L2 - Ln-1 are thermally connected by a plurality of buried vias 5. The buried vias 5 form columns trough the inner layers L2 - Ln-1. Also in this embodiment the buried vias 5 are arranged to form an interleaved heat exchange structure 13 for a heat exchange between the top layer L1 and the bottom layer Ln.

Fig. 9 shows schematic top views of the layers of the multilayer printed circuit board of Fig. 8. The top layer L1 is provided with 48 blind vias 3, which thermally connect the heat receiving area 2, i.e., the copper area of the top layer L1, to the copper area of the upper adjacent inner layer L2. Similarly, 48 blind vias 3 are provided in the bottom layer Ln, which thermally connect the heat dissipating area 4, i.e., the copper area of the bottom layer Ln, to the copper area of the lower adjacent inner layer Ln-1. The inner layers L2 - Ln-1 are thermally connected by 80 buried vias 5. Of course, other numbers of blind vias 3 and buried vias 5 may be used. The copper areas of the inner layers L2 - Ln-1 consist of a plurality of essentially rectangular blocks 11. A first subset of these blocks 11 is connected to the first potential P1, which is indicated through the solid outline, whereas a second subset is connected to the second potential P2, which is indicated through the short-dashed outline. As is apparent, the columns formed by the buried vias 5 are combined into larger columns, which are arranged in a chess pattern 14. A first set of those columns is connected to the first potential P1, i.e. the top layer L1, whereas a second set of columns is connected to the second potential P2, i.e. the bottom layer Ln. The two sets of columns are interleaved and form a brush-like heat exchange structure.

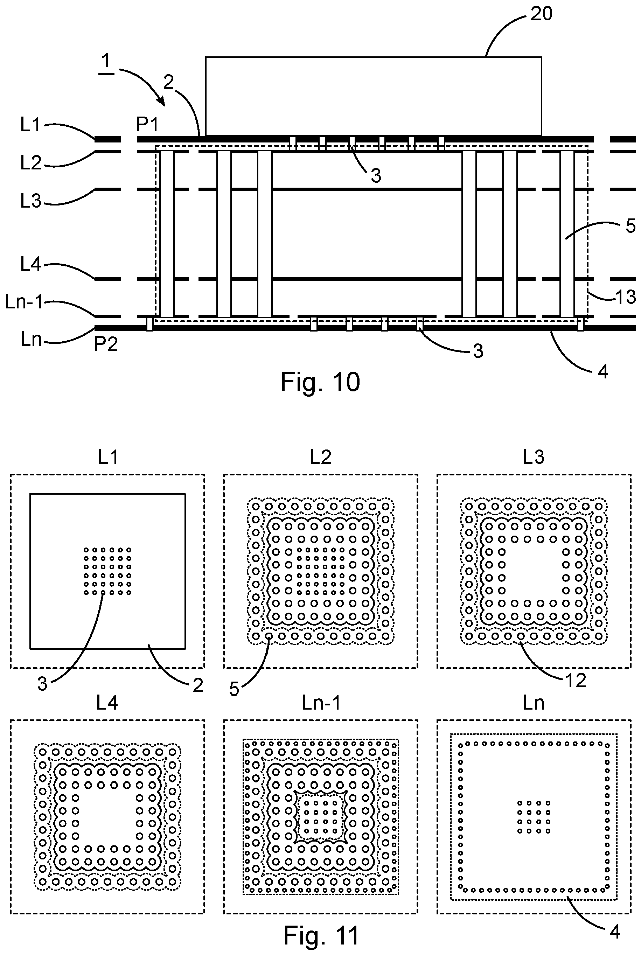

Fig. 10 shows a schematic cross section of a multilayer printed circuit board 1 according to a fourth embodiment of the invention. Only the conductors of the respective conductor layer are shown for each layer L1 - Ln. A copper area of the top layer L1 is provided as a heat receiving area 2 for heat generated by a heat generating component. Further copper areas are arranged on the inner layers L2 - Ln-1 and the bottom layer Ln. The heat receiving area 2 is thermally connected to an upper adjacent inner layer L2 by a plurality of blind vias 3. Similarly, the copper area of the bottom layer Ln, which constitutes a heat dissipating area 4, is thermally connected to a lower adjacent inner layer Ln-1 by a plurality of blind vias 3. The inner layers L2 - Ln-1 are thermally connected by a plurality of buried vias 5. The buried vias 5 form columns trough the inner layers L2 - Ln-1. Also in this embodiment the buried vias 5 are arranged to form an interleaved heat exchange structure 13 for a heat exchange between the top layer L1 and the bottom layer Ln.

Fig. 11 shows schematic top views of the layers of the multilayer printed circuit board of Fig. 10. The top layer L1 is provided with 36 blind vias 3, which thermally connect the heat receiving area 2, i.e., the copper area of the top layer L1, to the copper area of the upper adjacent inner layer L2. The bottom layer Ln is provided with 87 blind vias 3, which thermally connect the heat dissipating area 4, i.e., the copper area of the bottom layer Ln, to the copper area of the lower adjacent inner layer Ln-1. The inner layers L2 - Ln-1 are thermally connected by 88 buried vias 5. Of course, other numbers of blind vias 3 and buried vias 5 may be used. The copper areas of the inner layers L2 - Ln-1 consist of rectangular areas 12. A first subset of these rectangular areas 12 is connected to the first potential P1, which is indicated through the solid outline, whereas a second subset is connected to the second potential P2, which is indicated through the short-dashed outline. The two subset of rectangular areas 12 are interleaved and form a nested heat exchange structure. As an alternative to rectangular areas 12, also ring-shaped areas may be used.

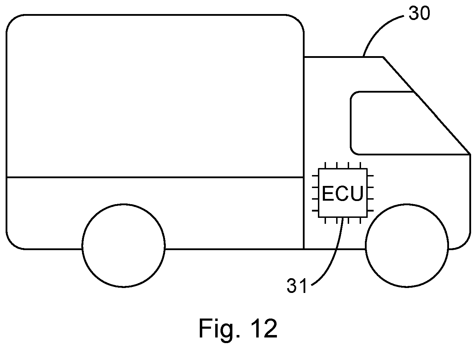

Fig. 12 schematically shows a motor vehicle 30 comprising an electronic control unit 31. The an electronic control unit 31 comprises a multilayer printed circuit board according to the invention. As such an electronic control unit 31 shows an improved heat dissipation capability, it can be used in a wider temperature range. In this example, the motor vehicle 30 is a utility vehicle, in particular a truck. Of course, also other types of motor vehicles 30 may make use of such an electronic control unit 31, such as passenger cars or busses.

Also other embodiments may be utilized by one skilled in the art without departing from the scope of the present disclosure. The disclosure resides therefore in the claims herein after appended.

### List of Reference signs (part of the specification):

- 1: multilayer printed circuit board
- 2: heat receiving area
- 3: blind via
- 4: heat dissipating area
- 5: buried via
- 6: heat conducting material
- 7: cut-out
- 8: circular area
- 9: stripe
- 10: sheet
- 11: rectangular block
- 12: rectangular area
- 13: heat exchange structure
- 14: chess pattern
- 20: heat generating component
- 30: motor vehicle
- 31: electronic control unit
- C1 - Cn: conductor layer
- IL1 - ILn-1: insulation layer
- L1: top layer
- L2 - Ln-1: inner layer
- Ln: bottom layer
- P1: first potential
- P2: second potential
- RA: top resist layer
- RB: bottom resist layer

## Claims

1. A multilayer printed circuit board (1) comprising a bottom layer (Ln), a top layer (L1), and two or more inner layers (L2 - Ln-1), wherein a heat receiving area (2) of the top layer (L1) is thermally connected to an upper adjacent inner layer (L2) by one or more blind vias (3) and a heat dissipating area (4) of the bottom layer (Ln) is thermally connected to a lower adjacent inner layer (Ln-1) by one or more blind vias (3), and wherein the two or more inner layers (L2 - Ln-1) are thermally connected by a plurality of buried vias (5), **characterized in that** the plurality of buried vias (5) are arranged to form an interleaved heat exchange structure (13) for a heat exchange between the top layer (L1) and the bottom layer (Ln).

2. The multilayer printed circuit board (1) of claim 1, wherein the top layer (L1), the bottom layer (Ln), and the inner layers (L2 - Ln-1) are provided with a heat conducting material (6).

3. The multilayer printed circuit board (1) of claim 2, wherein the heat conducting material is copper.

4. The multilayer printed circuit board (1) of one of the preceding claims, wherein the heat receiving area (2) of the top layer (L1) and the heat dissipating area (4) of the bottom layer (Ln) are electrically isolated from each other.

5. The multilayer printed circuit board (1) of one of the preceding claims, wherein the buried vias (5) form columns through the inner layers (L2 - Ln-1).

6. The multilayer printed circuit board (1) of claim 5, wherein the columns are arranged in sheets (10).

7. The multilayer printed circuit board (1) of claim 5, wherein the columns are arranged in rings or rectangles (9).

8. The multilayer printed circuit board (1) of claim 5, wherein the columns are arranged in a chess pattern (14).

9. The multilayer printed circuit board (1) of one of the preceding claims, wherein the multilayer printed circuit board (1) comprises four inner layers (L2 - Ln-1).

10. The multilayer printed circuit board (1) of one of the preceding claims, further comprising a heat generating component (20) arranged on the heat receiving area (2) of the top layer (L1).

11. The multilayer printed circuit board (1) of claim 10, wherein the heat receiving area (2) of the top layer (L1) is larger than a footprint of the heat generating component (20).

12. The multilayer printed circuit board (1) of one of the preceding claims, wherein the heat dissipating area (4) of the bottom layer (Ln) is larger than the heat receiving area (2) of the top layer (L1).

13. An electronic control unit (31) for a motor vehicle (30) comprising a multilayer printed circuit board (1) according to one of the preceding claims.

14. A motor vehicle (30) comprising an electronic control unit (31) according to claim 13.
